## Europäisches Patentamt

## European Patent Office

## Office européen des brevets

(19)

(11) Veröffentlichungsnummer: **0 044 066**

**A2**

(12) **EUROPÄISCHE PATENTANMELDUNG**

(21) Anmeldenummer: **81105463.4**

(22) Anmeldetag: **13.07.81**

(51) Int. Cl.³: **H 03 K 5/02**

(30) Priorität: **16.07.80 DE 3026951**

(43) Veröffentlichungstag der Anmeldung:
**20.01.82 Patentblatt 82/3**

(84) Benannte Vertragsstaaten:
**DE FR GB**

(71) Anmelder: **SIEMENS AKTIENGESELLSCHAFT Berlin und München**
**Postfach 22 02 61**
**D-8000 München 22(DE)**

(72) Erfinder: **Horninger, Karlheinrich, Dr.**
**Riederinger Strasse 9**
**D-8011 Eglharting(DE)**

(54) **Treiberstufe in integrierter MOS-Schaltkreistechnik mit grossem Ausgangssignalverhältnis.**

(57) Die vorliegende Erfindung bezieht sich auf eine Treiberstufe in integrierter MOS-Schaltkreistechnik mit großem Ausgangssignalverhältnis, bei der als Steuerstufen und als Ausgangsstufe jeweils zwischen den Versorgungsspannungsklemmen liegende, als Sourcefolger bzw. Inverter wirkende Reihenschaltungen aus jeweils einem ersten und einem zweiten MOSFET vorgesehen sind. Bekannte Treiberstufen mit großem Ausgangssignalverhältnis verwenden als Steuerstufen und als Ausgangsstufe Reihenschaltungen aus je·einem Verarmungstyp-MOSFET und einem Anreicherungstyp-MOSFET. Sie haben den Nachteil, daß jeweils in einem ihrer beiden statischen Zustände ein großer Querstrom fließt. Erfindungsgemäß wird u. a. zur wesentlichen Verringerung dieses Querstroms in der Ausgangsstufe dem Verarmungstyp-MOSFET (T5) ein Anreicherungstyp-MOSFET (T5') parallelgeschaltet, wobei das W/L-Verhältnis des Verarmungstyp-MOSFET (T5) sehr klein gewählt wird. Zur Verbesserung des Ausgangsverhältnisses ist außerdem erfindungsgemäß ein Bootstrap-Kondensator (C$_B$) vorgesehen, der in bekannter Weise die Gatespannung eines der Ausgangs-MOSFET über die Betriebsspannung hochkoppelt. Die Erfindung bietet den Vorteil, daß eine Treiberstufe in integrierter MOS-Schaltkreistechnik mit großem Ausgangssignalverhältnis geschaffen wurde, die jeweils in ihrem ersten bzw. in ihrem zweiten Betriebszustand eine im Verhältnis zu der genannten bekannten Treiberstufe geringe Verlustleistung hat. Dies wiederum bringt den Vorteil mit sich, daß ansonsten bestehende Wärmeprobleme bekannter Art bei Verwendung solcher erfindungsgemäßen Treiberstufen nicht mehr auftreten.

FIG 2

SIEMENS AKTIENGESELLSCHAFT

Berlin und München

Unser Zeichen

VPA

80 P 7109 E

Treiberstufe in integrierter MOS-Schaltkreistechnik mit großem Ausgangssignalverhältnis

Die vorliegende Erfindung bezieht sich auf eine Treiberstufe in integrierter MOS-Schaltkreistechnik mit großem Ausgangssignalverhältnis, bei der als Steuerstufen und als Ausgangsstufe jeweils zwischen den Versorgungsspannungsklemmen liegende, als Sourcefolger bzw. Inverter wirkende Reihenschaltungen aus jeweils einem ersten und einem zweiten MOSFET vorgesehen sind.

Aus R.W. Knepper: "Dynamic Depletion Mode: An E/D MOSFET Circuit Method for Improved Performance", IEEE J. of Solid State Circuits, Oct. 78, Vol. SC-13, No. 5, pp. 542 bis 548 ist eine Treiberstufe der genannten Art bekannt, bei der die jeweils auf Massepotential liegenden zweiten MOSFET als Anreicherungs(enhancement)-Typ und die jeweils ersten MOSFET als Verarmungs(depletion)-Typ ausgeführt sind, bei der jeweils der gemeinsame Verbindungspunkt zwischen dem ersten und dem zweiten MOSFET der Steuerstufen bzw. der Ausgangsstufe den Signalausgang der jeweils betreffenden Stufe bildet, bei der jeweils der Signalausgang einer der Steuerstufen mit dem Gate des ersten bzw. des zweiten MOSFET des Inverters der Ausgangsstufe verbunden ist und bei der der Signalausgang des Inverters der Ausgangsstufe dem Ausgang der Treiberstufe entspricht. Diese bekannte Schaltungsanordnung ist mit einem großen Ausgangssignalverhältnis im Vergleich zu früher bekannten Treiberstufen ausgestattet. Diese gegenüber früher bekannten Treiberstufen verbesserte Treiberstufe hat jedoch den Nachteil, daß sie in einem ihrer Betriebszustände einen relativ hohen Stromverbrauch und damit eine relativ hohe Verlustlei-

Pap 1 Reu / 14.7.1980

stung bedingt.

Der vorliegenden Erfindung liegt die Aufgabe zugrunde, eine Treiberstufe der genannten Art zu schaffen, die trotz des angestrebten großen Ausgangssignalverhältnisses eine wesentlich kleinere Verlustleistung aufweist.

Die der Erfindung zugrundeliegende Aufgabe wird durch eine Treiberstufe gemäß dem Oberbegriff des Hauptanspruchs gelöst. Diese neue Treiberstufe ist erfindungsgemäß dadurch gekennzeichnet, daß dem als Verarmungs-(depletion)-Typ ausgeführten ersten Ausgangsstufen-MOSFET ein als Anreicherungs(enhancement)-Typ ausgeführter, source-, drain- und gatemäßig parallelgeschalteter MOSFET zugeordnet ist, daß zwischen den Gates der beiden parallelgeschalteten MOSFET, nämlich des ersten Ausgangsstufen-MOSFET und des parallelgeschalteten MOSFET und dem Verbindungspunkt zwischen diesen und dem zweiten Ausgangsstufen-MOSFET, nämlich dem Ausgang der Treiberstufe, ein Bootstrap-Kondensator geschaltet ist, daß das W/L-Verhältnis des ersten Ausgangsstufen-MOSFET gegenüber dem des entsprechenden MOSFET der bekannten Treiberstufe verkleinert ist und das W/L-Verhältnis des parallelgeschalteten MOSFET gegenüber dem des ersten Ausgangsstufen-MOSFET groß ausgelegt ist und daß der als Verarmungs(depletion)-Typ ausgeführte erste MOSFET der Steuerstufe, deren Signalausgang mit den Gates des ersten Ausgangsstufen-MOSFET und des parallelgeschalteten MOSFET verbunden ist, durch einen als Anreicherungs-(enhancement)-Typ ausgeführten ersten Steuerstufen-MOSFET ersetzt ist.

Die vorliegende Erfindung bietet den Vorteil, daß eine Treiberstufe in integrierter MOS-Schaltkreistechnik mit großem Ausgangssignalverhältnis geschaffen wurde, die jeweils in ihrem ersten bzw. in ihrem zweiten Betriebszustand eine im Verhältnis zu der genannten bekannten Treiberstufe geringe Verlustleistung hat. Dies wiederum bringt den Vorteil mit sich, daß ansonsten bestehende Wärmeprobleme bekannter Art bei Verwendung solcher erfindungsgemäßen Treiberstufen nicht mehr auftreten.

Eine Weiterbildung der vorliegenden Erfindung ist durch die in dem Unteranspruch angegebenen Merkmale gekennzeichnet.

Im folgenden wird die Erfindung anhand mehrerer, die bekannte Treiberstufe und Ausführungsbeispiele für die erfindungsgemäße Treiberstufe betreffender Figuren im einzelnen erläutert.

Fig. 1 zeigt das Schaltbild der genannten bekannten Treiberstufe.

Fig. 2 zeigt das Schaltbild eines ersten Ausführungsbeispiels für die erfindungsgemäße Treiberstufe.

Fig. 3 zeigt das Schaltbild eines verbesserten Ausführrungsbeispiels für die erfindungsgemäße Treiberstufe.

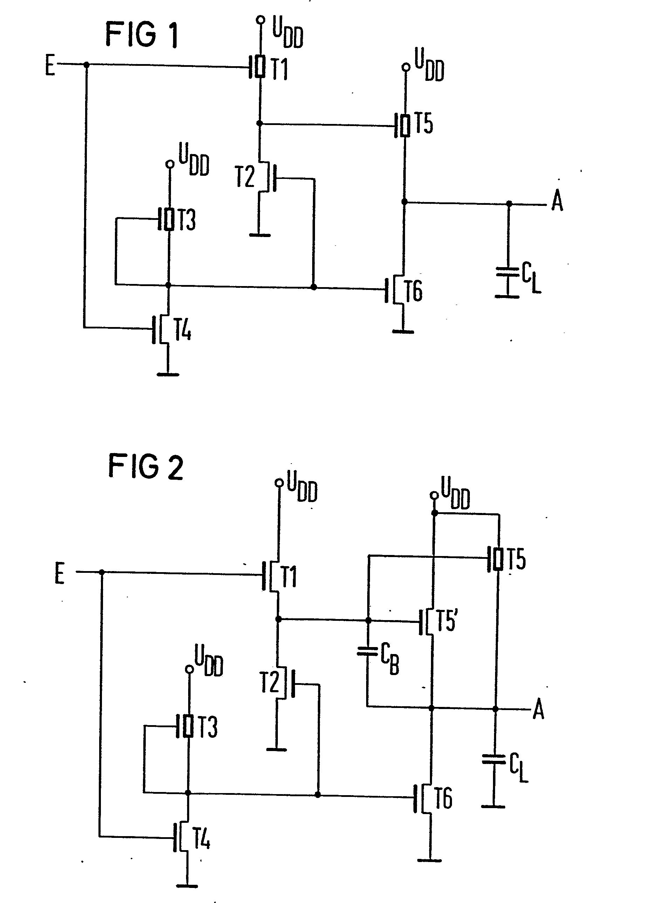

Wie bereits erläutert, zeigt Fig. 1 das Schaltbild der genannten bekannten Treiberstufe. Sie besteht insgesamt aus einer ersten Steuerstufe mit einem als Verarmungs-(depletion)-Typ ausgeführten ersten MOSFET T1 und einem als Anreicherungs(enhancement)-Typ ausgeführten zweiten MOSFET T2, einer zweiten Steuerstufe mit einem dritten als Verarmungs(depletion)-Typ ausgeführten MOSFET T3 und einem vierten als Anreicherungs(enhancement)-Typ ausgeführten MOSFET T4 und aus einer Ausgangsstufe mit einem fünften als Verarmungs(depletion)-Typ ausgeführten MOSFET T5 und einem sechsten als Anreicherungs(enhancement)-Typ ausgeführten MOSFET T6. Die beiden Steuerstufen und die Ausgangsstufe sind jeweils als Sourcefolger bzw. als Inverter wirkend zwischen die Betriebsspannungs-klemmen $U_{DD}$ und Masse gelegt. Der Eingang E dieser Treiberstufe ist zum einen mit dem Gate des ersten MOSFET T1 und zum zweiten mit dem Gate des vierten MOSFET T4 verbunden. Der Verbindungspunkt zwischen Source des ersten MOSFET T1 und Drain des zweiten MOSFET T2 ist mit dem Gate des fünften MOSFET T5 verbunden. Der Verbindungspunkt zwischen Source des dritten MOSFET T3 und Drain des vierten MOSFET T4 ist zum einen mit dem Gate des dritten MOSFET T3 und zum anderen mit dem Gate des zweiten MOSFET T2 und dem Gate des sechsten MOSFET T6 verbunden. Der Verbindungspunkt zwischen Source des fünften MOSFET T5 und Drain des sechsten MOSFET T6 stellt den Ausgang A der Treiberstufe dar, der mit einer kapaziti-ven Last $C_L$ beaufschlagt ist. In dem Schaltzustand, in dem jeweils eine der Stufen an dem Verbindungspunkt der betreffenden MOSFET das Potential 0 hat, fließt durch die jeweils betreffende Stufe ein Querstrom von der Betriebsspannungsquelle $U_{DD}$ gegen Masse. Nachdem insbesondere die Ausgangsstufe, in diesem Falle bestehend aus dem fünften MOSFET T5 und dem sechsten MOSFET T6, Transistoren mit relativ kleinem Kanalwiderstand hat, ist der genannte Querstrom nachteilhafterweise groß, was zu einer unerwünscht hohen Verlustleistung führt.

Fig. 2 zeigt, wie bereits erläutert, das Schaltbild eines ersten Ausführungsbeispiels für die erfindungsgemäße Treiberstufe. Sie unterscheidet sich in ihrer Schaltungsstruktur von der bekannten Treiberstufe dadurch, daß dem als Verarmungs(depletion)-Typ ausgeführten ersten Ausgangsstufen-MOSFET T5 ein als Anreiche-rungs(enhancement)-Typ ausgeführter, source-, drain-und gatemäßig parallelgeschalteter MOSFET T5' zugeordnet ist, daß zwischen den Gates der beiden parallelgeschalteten MOSFET, nämlich des ersten Ausgangsstufen-MOSFET T5 und des parallelgeschalteten MOSFET T5' und dem Verbindungspunkt zwischen diesen und dem zweiten Ausgangsstufen-MOSFET T6, nämlich dem Ausgang A der Treiberstufe, ein Bootstrap-Kondensator $C_B$ geschaltet ist, wobei das W/L-Verhältnis des parallelgeschalteten MOSFET T5' gegenüber dem des ersten Ausgangsstufen-MOSFET T5 groß ausgelegt ist, und daß der als Verarmungs-(depletion)-Typ ausgeführte erste MOSFET der Stufe, deren Signalausgang mit den Gates des ersten Ausgangsstufen-MOSFET T5 und des parallelgeschalteten MOSFET T5' verbunden ist, durch einen als Anreicherungs(enhancement)-Typ ausgeführten ersten Steuerstufen-MOSFET T1 ersetzt ist.

Durch den erfindungsgemäßen Aufbau der Treiberstufe ist nun vorteilhafterweise sichergestellt, daß in keinem der beiden möglichen statischen Schaltzustände der einzelnen Stufen der Treiberstufe eine nachteilig große Verlustleistung auftritt. Dies sei im folgenden anhand einer Erläuterung der Potentialzustände an den einzelnen Knoten der erfindungsgemäßen Schaltungsanordnung entsprechend den verschiedenen möglichen statischen Schaltzuständen erläutert.

Fall 1 (Eingang E liegt auf 0 Volt):
  Wenn der Eingang E auf dem Potential 0 liegt, ist der erste MOSFET T1 der ersten Steuerstufe gesperrt. Ebenfalls ist der untere MOSFET der zweiten Steuerstufe, nämlich der vierte MOSFET T4, gesperrt. Aus diesem Grunde liegt der Verbindungspunkt zwischen den beiden MOSFET der zweiten Steuerstufe, nämlich T3 und T4, dadurch, daß der als Verarmungstyp ausgeführte MOSFET T3 als Lastelement geschaltet ist, auf dem Betriebsspannungspotential $U_{DD}$, nämlich beispielsweise +5 Volt. Dieses Potential teilt sich dem Gate des zweiten MOSFET T2 der zweiten Steuerstufe und dem Gate des zweiten Ausgangsstufen-MOSFET T6 mit. Die beiden zuletzt genannten MOSFET werden demzufolge aufgesteuert, so daß sowohl der Verbindungspunkt zwischen den MOSFET T1 und T2 als auch der Verbindungspunkt zwischen dem MOSFET T5 bzw. T5' und dem MOSFET T6 jeweils auf dem Potential O liegen. Nachdem der erste MOSFET T1 der ersten Steuerstufe gesperrt ist, fließt kein Strom durch diesen MOSFET. Es fließt ebenfalls kein Strom durch den MOSFET T3. Lediglich durch den ersten Ausgangsstufen-MOSFET T5 fließt ein geringer Strom über den zweiten Ausgangsstufen-MOSFET T6 gegen Masse, dessen geringer Wert durch die Hochohmigkeit des MOSFET T5 bestimmt ist. Es entsteht somit eine geringe Verlustleistung.

Fall 2 (Eingang E liegt auf hohem Potential, beispielsweise +5 Volt):

In diesem Fall werden der erste MOSFET T1 der ersten Steuerstufe und der untere MOSFET der zweiten Steuerstufe, nämlich T4, aufgesteuert. Damit liegt an dem Verbindungspunkt zwischen dem MOSFET T1 und dem MOSFET T2 ein Potential von $5-U_T$, das auch auf das Gate des parallelgeschalteten MOSFET T5' durchgreift. Der Verbindungspunkt zwischen den MOSFET T3 und T4 liegt in diesem Fall auf O Volt, welches Potential sich jeweils dem Gate des MOSFET T2 bzw. des MOSFET T6 mitteilt. Die beiden zuletzt genannten MOSFET bleiben dabei gesperrt, so daß das zuvor erwähnte Potential des Verbindungspunktes zwischen T1 und T2 aufrechterhalten bleibt. Über den Bootstrap-Kondensator $C_B$ wird die Gatespannung des MOSFET T5' in an sich bekannter Weise über die Betriebsspannung $U_{DD}$ hochgekoppelt. Dadurch gelangt die volle Betriebsspannung $U_{DD}$ an den Ausgang A. Da dies ein dynamischer Effekt ist, würde nach einer bestimmten Zeit der Ausgang wieder auf ein Potential $U_{DD}-U_T$ absinken. Dies verhindert jedoch der zu T5' parallel liegende MOSFET T5, der, wie bereits erläutert, vom Verarmungs(depletion)-Typ ist. Er hält den Ausgang A auf dem Potential $U_{DD}$. Da das W/L-Verhältnis dieses MOSFET klein gehalten ist, d. h. der Kanalwiderstand groß ist, fließt ein geringer Strom, der nicht nennenswert zur Gesamtverlustleistung beiträgt.

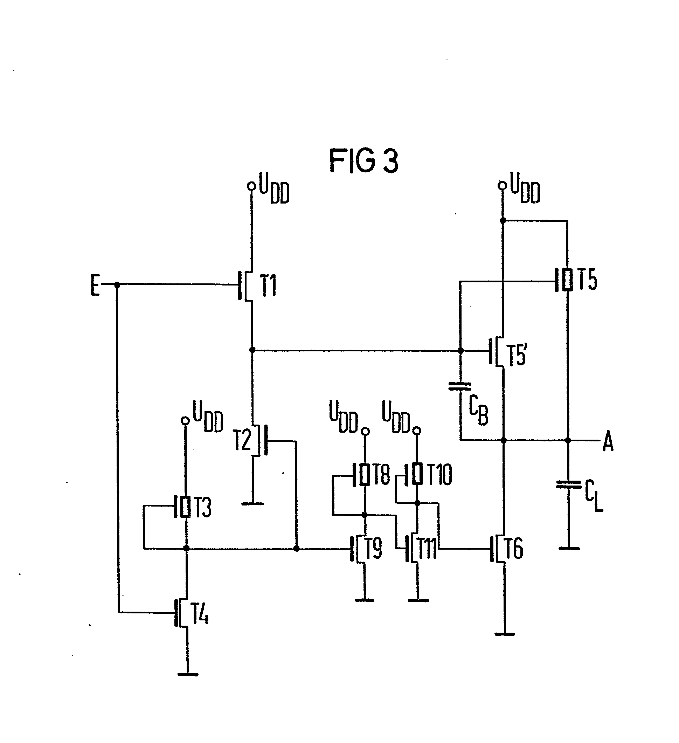

Eine Verbesserung der Eigenschaften der erfindungsgemäßen Treiberstufe kann dadurch erzielt werden, daß zwischen dem Steuerstufen-Signalausgang, der auf das Gate des zweiten Ausgangsstufen-MOSFET T6 wirkt und das Gate des zweiten Ausgangsstufen-MOSFET T6 zwei in an sich bekannter Weise hintereinandergeschaltete, aus je einem als Verarmungs(depletion)-Typ ausgeführten ersten Hilfs-MOSFET T8 bzw. T10 und als Anreicherungs(enhancement)-Typ ausgeführten zweiten Hilfs-MOSFET T9 bzw. T11 gebildete Hilfsinverterstufen angeordnet sind. Diese hintereinander angeordneten Inverter verzögern das Signal, das von der Steuerstufe - bestehend aus den MOSFET T3 und T4 - kommt, womit das Signal verzögert an das Gate des MOSFET T6 gelegt wird, vergl. Fig. 3. Durch diese verbessernde Maßnahme wird eine steilere Anstiegsflanke für das Steuersignal an dem Gate des parallelgeschalteten MOSFET T5' erreicht. Allerdings wird dabei eine etwas höhere Schaltverzögerungszeit in Kauf genommen.

2 Patentansprüche

3 Figuren

Patentansprüche

1. Treiberstufe in integrierter MOS-Schaltkreistechnik mit großem Ausgangssignalverhältnis, bei der als Steuerstufen und als Ausgangsstufe jeweils zwischen den Versorgungsspannungsklemmen liegende, als Sourcefolger bzw. Inverter wirkende Reihenschaltungen aus jeweils einem ersten und einem zweiten MOSFET vorgesehen sind, wobei vorzugsweise die jeweils auf Massepotential liegenden zweiten MOSFET als Anreicherungs(enhancement)-Typ und die jeweils ersten MOSFET als Verarmungs(depletion)-Typ ausgeführt sind, bei der jeweils der gemeinsame Verbindungspunkt zwischen dem ersten und dem zweiten MOSFET der Steuerstufen bzw. der Ausgangsstufe den Signalausgang der jeweils betreffenden Reihenschaltung bildet, bei der jeweils der Signalausgang einer der Steuerstufen mit dem Gate des ersten bzw. des zweiten MOSFET des Inverters der Ausgangsstufe verbunden ist und bei der der Signalausgang des Inverters der Ausgangsstufe dem Ausgang der Treiberstufe entspricht, d a d u r c h  g e k e n n -z e i c h n e t ,  daß dem als Verarmungs(depletion)-Typ ausgeführten ersten Ausgangsstufen-MOSFET (T5) ein als Anreicherungs(enhancement)-Typ ausgeführter, source-, drain- und gatemäßig parallelgeschalteter MOSFET (T5') zugeordnet ist, daß zwischen den Gates der beiden parallelgeschalteten MOSFET, nämlich des ersten Ausgangsstufen-MOSFET (T5) und des parallelgeschalteten MOSFET (T5') und dem Verbindungspunkt zwischen diesen und dem zweiten Ausgangsstufen-MOSFET (T6), nämlich dem Ausgang (A) der Treiberstufe, ein Bootstrap-Kondensator ($C_B$) geschaltet ist, daß das W/L-Verhältnis des ersten Ausgangsstufen-MOSFET (T5) gegenüber dem des entsprechenden MOSFET der bekannten Treiberstufe verkleinert ist und das W/L-Verhältnis des parallelgeschalteten MOSFET (T5') gegenüber dem des ersten Ausgangsstufen-MOSFET (T5) groß ausgelegt ist und daß der als Verarmungs-(depletion)-Typ ausgeführte erste MOSFET der Steuerstufe, deren Signalausgang mit den Gates des ersten Ausgangsstufen-MOSFET (T5) und des parallelgeschalteten MOSFET (T5') verbunden ist, durch einen als Anreicherungs(enhancement)-Typ ausgeführten ersten Steuerstufen-MOSFET (T1) ersetzt ist.

2. Treiberstufe nach Anspruch 1, d a d u r c h  g e - k e n n z e i c h n e t ,  daß zwischen dem Steuerstufen-Signalausgang, der auf das Gate des zweiten Ausgangsstufen-MOSFET (T6) wirkt, und dem Gate des zweiten Ausgangsstufen-MOSFET (T6) zwei in an sich bekannter Weise hintereinandergeschaltete, aus je einem als Verarmungs(depletion)-Typ ausgeführten ersten Hilfs-MOSFET (T8 bzw. T10) und als Anreicherungs(enhancement)-Typ ausgeführten zweiten Hilfs-MOSFET (T9 bzw. T11) gebildete Hilfsinverter-Stufen angeordnet sind.

1/2

FIG 1

FIG 2

FIG 3

2/2

0044066